# EUROPÄISCHE PATENTSCHRIFT

(11) **EP 2 884 736 B1**
(45) Veröffentlichungstag und Bekanntmachung des Hinweises auf die Patenterteilung: **03.07.2019**
(21) Anmeldenummer: 14196265.4
(22) Anmeldetag: 04.12.2014
(51) Int. Cl.: H04N 5/225

(54) **Kamera mit Heizelement**
Camera with heating element
Caméra dotée d'un élément chauffant

(30) Priorität: 11.12.2013 DE 102013020894
(43) Veröffentlichungstag der Anmeldung: 17.06.2015
(73) Patentinhaber: MEKRA LANG GmbH & Co. KG, 91465 Ergersheim (DE)
(72) Erfinder: Lang, Werner, 91465 Ergersheim (DE); Geissendörfer, Peter, 91465 Ergersheim (DE); Kunz, Manuel, 97285 Röttingen (DE); Witzke, Michael, 91522 Ansbach (DE); Centmayer, Stefan, 91465 Ergersheim (DE); Hornung, Michael, 91465 Ergersheim (DE)
(74) Vertreter: Kramer Barske Schmidtchen Patentanwälte PartG mbB

(56) Entgegenhaltungen:
- WO-A1-03/105465
- DE-A1-102007 043 516
- DE-B3-102012 015 398
- US-A1- 2006 171 704

## Beschreibung

Die vorliegende Erfindung betrifft eine Kamera mit wenigstens einem Heizelement, insbesondere eine Kamera mit wenigstens einem Heizelement zur Verwendung an einem Fahrzeug, z. B. einem Nutzfahrzeug.

In letzter Zeit ist es zunehmend angedacht, neben herkömmlichen Spiegeln als Einrichtungen zur indirekten Sicht entweder in Ergänzung oder als Ersatz für die Spiegel Kamerasysteme bzw. Bildaufhahmesysteme als Einrichtungen zur indirekten Sicht einzusetzen, bei denen eine Bildaufhahmeeinheit, wie beispielsweise eine Kamera, ein Aufnahmebild kontinuierlich erfasst, diese von der Bildaufnahmeeinheit erfassten (Video-)Daten, beispielsweise mittels einer Berechnungseinheit und gegebenenfalls nach Weiterbearbeitung, an eine im Fahrerhaus befindliche Wiedergabeeinrichtung geliefert werden, welche für den Fahrer dauerhaft und in Echtzeit und jederzeit einsehbar den entsprechend erfassten Sichtbereich und gegebenenfalls ergänzende Information, wie z. B. Kollisionshinweise, Abstände und Ähnliches, für den Bereich rund um das Fahrzeug darstellt.

Die Kameras werden üblicherweise am Fahrzeugäußeren angebracht und derart ausgerichtet, dass der gewünschte Sichtbereich der Fahrzeugumgebung erfasst wird. Die Kameras sind demnach Witterungseinflüssen am Standort des Fahrzeugs ausgesetzt. Insbesondere bei kalten Temperaturen, beispielsweise im Winter, können z. B. das Deckglas und/oder das Objektiv der Kameras mit Frost oder Kondensierungen bedeckt und somit die Funktionalitäten beeinträchtigt werden. Dabei sind es vor allem diejenigen optischen Elemente der Kamera, die sich am Gehäuseäußeren befinden und mit der Umgebung in unmittelbaren Kontakt treten und deshalb mit Frost und Kondensierungen bedeckt werden. Auch die Funktionalität und Aufnahmequalität von Kameras, die am Fahrzeug angeordnet sind, beispielsweise Rückfahrkameras, können durch den Frost und die Kondensierungen beeinflusst werden. Gerade bei wiederholter Kondensatbildung oder Frost können schließlich auch die Bauteile Schaden nehmen.

Um Frost bzw. Kondensierungen auf den äußeren optischen Elementen der Kamera zu vermeiden bzw. zu lösen, ist es bekannt, in der Kamera Heizelemente in der Nähe der optischen Elemente anzuordnen, beispielsweise objektseitig in der Nähe des Objektivs und/oder Deckglases. Dies ist oftmals verhältnismäßig aufwändig im Hinblick auf das Einbringen der Heizelemente in das Kameragehäuse während des Fertigungsprozesses. Außerdem weist das zumeist metallische Kameragehäuse eine bessere Wärmeleitfähigkeit im Vergleich zu den meistens aus Kunststoff oder Glas bestehenden optischen Elementen auf, weshalb bei einem Vorsehen der Heizelemente im Gehäuse der größere Teil der von den Heizelementen eingebrachten Wärmeenergie vom Kameragehäuse aufgenommen wird und gegebenenfalls sogar von den optischen Elementen weggeleitet wird, dass nur ein geringer Teil dieser Wärmeenergie zu einer Erwärmung der optischen Elemente führt.

Aus der DE 102 59 795 A1 ist eine Bilderzeugungsvorrichtung zum Einbau im Dachbereich oder im Außenspiegel eines Kraftfahrzeuges bekannt. Zwecks Erzielung klein dimensionierter Baugrößen sowie aus wärmetechnischen Überlegungen zeichnet sich die darin offenbarte Bilderzeugungsvorrichtung durch ihren Aufbau aus. Die Kamera hat wenigstens eine starre erste Platine für hochkomplexe Halbleiter mit wenigstens einem optischen Bildaufnahmesensor und eine zweite Platine für alle anderen Bauteile, wobei die erste und zweite Platine auf einer metallischen Grundplatte angeordnet, vorzugsweise eingeklebt, sind.

Die DE 10 2010015 398 B3 offenbart ein Spiegelersatzsystem für ein Fahrzeug. Das Spiegelersatzsystem enthält eine Bildaufnahmeeinheit, eine Versorgungseinheit und eine Wiedergabeeinheit. Die Wiedergabeeinheit ist dazu angepasst, im Fahrzeuginneren durch den Fahrer einsehbar angeordnet zu sein. Die Bildaufnahmeeinheit und die Versorgungseinheit sind bezüglich ihrer Abdichtung in voneinander getrennten Bauräumen angeordnet und jeweils getrennt von und außerhalb der Wiedergabeeinheit angeordnet.

Aus der DE 10 2011 199 594 A1 ist eine Vorrichtung für einen Kraftwagen bekannt, welche zur Verarbeitung von Bilddaten einer Bilderfassungseinheit mit einem Gehäuse ausgebildet ist, wobei im Gehäuse zumindest zwei Leiterplatten mit elektronischen Komponenten zur Verarbeitung der Bilddaten parallel und beabstandet zueinander angeordnet sind, und zumindest ein Wärmeableitelement im und/oder außen am Gehäuse angeordnet ist, welches zur Abführung von im Betrieb der elektronischen Komponenten erzeugten Wärme ausgebildet ist.

Die DE 10 2012 019 647 A1 betrifft eine Kamera für einen digitalen Rückspiegel. Die darin offenbarte Kamera weist ein Objektiv und einen Bildsensor auf, wobei das Objektiv und der Bildsensor in einem gemeinsamen Gehäuse angeordnet sind. Dabei ist die zum Betreiben der Kamera notwendige Elektronik an mindestens einer Seite des Objektivs angeordnet. Auf diese Weise wird erreicht, dass die Abwärme der Leiterplatten der Kameraelektronik, die mit dem Betrieb der Kamera anfällt, zum Heizen des Objektivs verwendet wird und keine separate Heizung notwendig ist. Somit kann der Stromverbrauch der Kamera reduziert werden.

Davon ausgehend ist es Aufgabe der Erfindung eine Kamera bereitzustellen, die dauerhaft und zuverlässig im Freien eingesetzt, Temperaturunterschieden zugrunde liegendem Frost und Kondensierungen standhalten und deshalb fehlerfrei arbeiten kann, während eine kostengünstige und einfache Herstellung gewährleistet ist.

Aus der WO 03/105465 A1 ist ein optisches Modul und ein optisches System bekannt, dass ein Halbleiterelement, eine Linseneinheit und einen Linsenhalter aufweist, der ein MID (Molded Interconnected Device) mit integrierten Leiterbahnen ist und somit den Schaltungsträger für das Halbleiterelement bildet.

Die US 2006/0171704 A1 offenbart ein Bildsystem für ein Fahrzeug mit einem Kameramodul, das an einem Fahrzeug anbringbar ist, und einer Steuerung. Das Kameramodul weist ein Plastikgehäuse auf, in dem ein Bildsensor untergebracht ist, der dazu ausgebildet ist, Bilder einer Fahrzeugumgebung aufzunehmen. Die Steuerung ist dazu ausgebildet, die vom Bildsensor erfassten Bilder zu verarbeiten. Die Bereiche des Gehäuses können miteinander mittels Laserschweißen und/oder Ultraschallschweißen verbunden werden, um den Bildsensor und damit verbundene Komponenten innerhalb des Plastikgehäuses abzudichten. Das Gehäuse kann einen Lüftungsbereich aufweisen, der zumindest teilweise wasserdampfdurchlässig ist, um es dem Wasserdampf zu ermöglichen, dorthin durchzugelangen. Hingegen ist der Lüftungsbereich dazu ausgebildet, Wassertropfen und/oder andere Partikel nicht hindurchzulassen. Das Gehäuse kann am Fahrzeug zwischen einer Ruheposition und einer Betriebsposition bewegt werden, in der der Bildsensor in Richtung der Fahrzeugumgebung gerichtet ist.

Aus der DE 10 2007 043 516 A1 ist eine Anordnung zum Betrieb eines elektronischen Kameramoduls bekannt, bei der im thermischen Kontakt mit dem Kameramodul ein Spannungsregelbaustein für die Spannungsversorgung des Kameramoduls angeordnet ist, dessen Eingangsspannung in Abhängigkeit von der Umgebungstemperatur mit einem Temperatursignal des Kameramoduls oder des Kameraventils veränderbar ist und dessen Verlustleistung über die Eingangsspannung des Spannungsregelbausteins steuerbar ist. Der Spannungsregelbaustein ist dabei bevorzugt ein LDO-Regler, dessen Eingangsspannung über einen Impulsweitmodulator veränderbar ist.

Diese Aufgabe wird mit einer Kamera mit den Merkmalen des Anspruchs 1 gelöst. Bevorzugte Ausführungsformen sind in den abhängigen Ansprüchen angegeben.

Der Erfindung liegt der Gedanke zugrunde, eine Kamera zur Verwendung in Fahrzeugen, insbesondere Nutzfahrzeugen, vorzusehen, die ein Gehäuse, wenigstens ein im Gehäuse angeordnetes optisches Element, eine im Gehäuse angeordnete und zumindest eine Platine aufweisende Platinengruppe, die jeweils mit einer aktiven Schaltung zum Ausführen einer direkten Kamerafunktion versehen ist, und zumindest ein Heizelement aufweist, das zum Erwärmen der Platinengruppe, des optischen Elements und/oder des Gehäuses angepasst ist. Das zumindest eine Heizelement ist unmittelbar auf einer der Platinen der Platinengruppe angebracht, wobei darunter ebenfalls ein teilweises Integrieren oder Einbetten des zumindest einen Heizelements in der Platine der Platinengruppe zu subsummieren ist. Das Anordnen der Heizelemente unmittelbar auf einer der Platinen der Platinengruppe kann alternativ oder zusätzlich zu weiteren in der Kamera angeordneten Heizvorrichtungen erfolgen, beispielsweise Heizvorrichtungen die relativ zum optischen Element objektseitig angeordnet sind.

Das bevorzugt zu erwärmende Bauteil ist dasjenige Bauteil, das mit der Umgebung in direktem Kontakt steht und deshalb den Witterungseinflüssen ausgesetzt ist. Ist die Kamera beispielsweise mit einem Deckglas versehen, soll primär das Deckglas, das auch als optisches Element bezeichnet werden kann, erwärmt und der darauf befindliche Frost bzw. die darauf niedergeschlagenen Kondensierungen beseitigt werden. Bei einer Kamera ohne Deckglas soll bevorzugt das optische Element, beispielsweise das Objektiv, erwärmt werden, das in diesem Fall mit der Umgebung in Kontakt steht. Üblicherweise ist die Kamera gegen Feuchtigkeitseintritt abgedichtet.

Im Rahmen der vorliegenden Offenbarung ist unter dem Begriff Platine eine Leiterplatte zu verstehen, die ein Träger für elektronische Bauteile ist. Die Platine dient der mechanischen Befestigung und der elektrischen Verbindung. Die Leiterplatte besteht vorzugsweise aus elektrisch isolierendem Material mit daran haftenden, leitenden Verbindungen.

Ferner ist unter einer aktiven Schaltung eine Schaltung zu verstehen, die beispielsweise Halbleiter aufweist. Die aktive Schaltung ist dazu angepasst, direkte Funktionen der Kamera auszuführen. Zu diesen direkten Kamerafunktionen zählen sämtliche Funktionen, die in direktem Zusammenhang mit der Bilderzeugung stehen, z. B. die Bilderfassung, Bildverarbeitung und Bilddarstellung. Als Beispiele sind die digitale Bilderfassungseinheit (oder Bildsensor genannt), die Videoübertragung mittels LVDS (Low Voltage Differential Signaling) Serializer, die Videoverarbeitung mittels Prozessoren aber auch eine elektrische Leistungsquelle zu nennen, die alle direkte Kamerafunktionen ausführen.

Im Gegensatz zu den direkten Kamerafunktionen fallen unter die indirekten Kamerafunktionen diejenigen Funktionen, die nicht für die Bilderzeugung notwendig sind. Beispiele hierzu sind Heizungen, eine Infrarotbeleuchtung oder ein Mikrofon.

Das Heizelement kann ein aktives Bauteil, beispielsweise ein Halbleiter, oder ein passives Bauteil, beispielweise eine Spule, ein elektrischer Widerstand , etc, sein. Außerdem kann es vorteilhaft sein, dass die Wärme, die von den auf der Platinengruppe angeordneten elektrischen Bauteilen erzeugt wird, ebenfalls zum Erwärmen des optischen Elements genutzt wird.

Durch das Anordnen des zumindest einen Heizelements unmittelbar auf der bereits in der Kamera vorhandenen Platine einer Platinengruppe, die eine aktive Schaltung zum Ausführen von direkten Kamerafunktionen aufweist, kann eine effiziente und kostengünstige Herstellung ermöglicht werden, da am Kameragehäuse keine Modifikationen vorgenommen werden müssen. Der Wärmeeintrag in die bevorzugt zu erwärmenden Bauteile ist vergrößert. Vorzugsweise ist zumindest ein Heizelement auf der Platine mittels einer Widerstandsschicht aufgebracht. Das zumindest eine Heizelement ist bevorzugt mit einer Leistungsquelle und beispielsweise einer Steuerungsvorrichtung verbunden, die dem zumindest einen Heizelement Steuerungssignale und elektrische Energie zuführt, die dann in Wärme umgesetzt wird. Die elektrische Verbindung zur Leistungsquelle und/oder zur Steuerungsvorrichtung befindet sich dabei bevorzugt ebenfalls aufgedruckt auf der Platine.

In einer Ausgestaltung ist die aktive Schaltung eine digitale Bilderfassungseinheit. In diesem Fall ist auf derjenigen Platine, auf der sich auch die digitale Bilderfassungseinheit befindet, ebenfalls zumindest ein Heizelement angeordnet, das mit den Leitungen auf der Platine zur Energiezufuhr verbunden ist. In einer weiteren Ausgestaltung ist die aktive Schaltung zum Übertragen von Videodaten an z. B. eine in einem Fahrzeug, insbesondere Nutzfahrzeug, durch den Fahrer einsehbar angeordnete Wiedergabeeinheit angepasst. Außerdem kann in einer weiteren Ausgestaltung die aktive Schaltung zur Verarbeitung der Videodaten angepasst sein, die nach der Verarbeitung an die Wiedergabeeinheit übertragen werden. In einer noch weiteren Ausgestaltung ist die aktive Schaltung als elektrische Leistungsquelle ausgebildet, die das zumindest eine Heizelement und/oder weitere elektronische Bauteile der Platinengruppe mit elektrischer Energie versorgt.

In einer Ausgestaltung weist die Platinengruppe eine einzige Platine auf, auf der die digitale Bilderfassungseinheit und das zumindest eine Heizelement gemeinsam unmittelbar angebracht sind. In einer weiteren Ausgestaltung weist die Platinengruppe zumindest zwei miteinander elektronisch oder mechanisch verbundene Platinen auf. Dabei ist die digitale Bilderfassungseinheit an einer Platine der Platinengruppe vorgesehen und das zumindest eine Heizelement ist an zumindest einer anderen Platine der Platinengruppe unmittelbar angebracht.

Vorzugsweise ist zumindest ein Wärmeleitelement vorgesehen, das zum Übertragen der Wärme des Heizelements und/oder der Platinengruppe in das Gehäuse zwischen dem zumindest einem Heizelement und dem Gehäuse angeordnet und angepasst ist. Bevorzugt ist das Wärmeleitelement großflächig mit einer großen Wärmeleitfläche ausgebildet, damit die vom Heizelement erzeugte Wärme effektiv in das Gehäuse und somit in das optische Element eingebracht werden kann. Damit bevorzugt vor allem das optische Element erwärmt wird, ist die Verbindung zwischen Heizelement und Gehäuse, die durch das Wärmeleitelement gebildet wird, in einer bevorzugten Ausführungsform in unmittelbarer Nähe des optischen Elements.

In einer weiteren Ausgestaltung ist zumindest ein Heizelement auf einer relativ zum optischen Element abgewandten Seite einer Platine der Platinengruppe angebracht. Alternativ oder zusätzlich dazu ist zumindest ein Heizelement auf einer relativ zum optischen Element zugewandten Seite einer Platine der Platinengruppe angebracht. Außerdem kann zumindest ein Heizelement dazu angeordnet und angepasst sein, einen konvektiven Wärmeeintrag in das optische Element, beispielsweise ein Objektiv mit Linsensystem, einzubringen, indem das Heizelement selbst mit zumindest einer Abstrahlfläche des Heizelements dem optischen Element zugewandt und/oder in dessen unmittelbarer Nähe angeordnet ist. In einer Ausführung der Erfindung, in der die Platinengruppe zumindest zwei Platinen aufweist, können Heizelemente auf einer relativ zum optischen Element abgewandten und/oder zugewandten Seite einer oder mehrerer Platinen der Platinengruppe angebracht sein.

In einer bevorzugten Ausgestaltung ist zumindest ein Wärmeleitelement unmittelbar zwischen einer Platine der Platinengruppe und dem Gehäuse und/oder unmittelbar zwischen zumindest einem Heizelement und dem Gehäuse angeordnet. Bevorzugt besteht das Wärmeleitelement aus einem Material mit guter Wärmeleitfähigkeit, beispielsweise aus Silber, Kupfer oder Aluminium. Vorzugsweise ist zumindest ein Wärmeleitelement ein wärmeleitender Kleber, eine Wärmeleitpaste und/oder ein Wärmeleitpad. Beispielsweise ist das Wärmeleitelement ein einkomponentiger Epoxidharzklebstoff aus wärmehärtenden, lösungsmittelfreien Reaktionsharzmassen oder ein mit Füllstoffen gefüllter Kleber, dem feste Bestandteile, wie Quarzmehl, Kreide, Metallpulver, Ruß, etc., zugesetzt werden, um die Wärmeleitfähigkeit zu verbessern. In einer Ausgestaltung ist zumindest eine Platine der Platinengruppe mittels zumindest einem Wärmeleitelement am Gehäuse befestigt. In einer bevorzugten Ausgestaltung erstreckt sich das Wärmeleitelement vollflächig über zumindest ein an einer Platine der Platinengruppe angebrachtes Heizelement, so dass die effektive Wärmeübertragungsfläche maximiert ist.

In einer weiteren Ausgestaltung ist im Gehäuse der Kamera ein Temperatursensor zum Erfassen der Temperatur innerhalb des Gehäuses vorgesehen. Der Temperatursensor erfasst die Temperatur im Gehäuse und übermittelt ein entsprechendes Temperatursignal an eine mit dem Temperatursensor verbundene Steuerungseinheit, die zum Steuern des zumindest einen Heizelements in Abhängigkeit der vom Temperatursensor erfassten Temperatur angepasst ist. Somit kann die Heizleistung von zumindest einem Heizelement in effektiver Weise gesteuert werden, d. h. dass zumindest ein Heizelement nur dann Wärme abgibt, wenn die im Gehäuse vorherrschende Temperatur einen vorbestimmten Schwellenwert unterschreitet. Auch soll die abgegebene Wärmeleistung von zumindest einem Wärmeleitelement zu der im Gehäuse vorherrschenden Temperatur proportional sein, beispielsweise bei niedrigen Temperaturen höher sein als bei höheren Temperaturen. Auch der Temperatursensor sowie zugehörige Steuerelemente für das Heizelement können auf einer Platine der Platinengruppe angeordnet sein.

In einer weiteren Ausgestaltung ist zumindest ein Heizelement ein von der Temperatur im Gehäuse abhängiges Heizelement, dessen Heizleistung von der im Gehäuse vorherrschenden Temperatur abhängt.

In bevorzugten Ausgestaltungen ist außerdem ein Deckglas vorgesehen, das in dieser Ausgestaltung das zu erwärmende optische Element darstellt. Das Deckglas schließt das Gehäuse objektseitig luft- und/oder wasserdicht ab. Das Deckglas ist vorzugsweise ebenfalls mit dem Gehäuse verbunden und wird ebenso durch das von zumindest einem Heizelement erwärmten Gehäuse erwärmt, so dass sich auf dem Deckglas bildender Frost oder Kondensierungen vermieden oder gelöst werden können.

Das Kameragehäuse weist im Inneren beispielsweise zylindrische Innenbereiche mit unterschiedlichen Durchmessern und Abstufungen auf, wobei auch andere Formen der Innenbereiche möglich sind. Eine Platine der Platinengruppe ist dabei vorzugsweise an einer ringförmigen Gehäuseflanschinnenfläche eines Innenbereichs befestigt. Das optische Element ist in einen zylindrischen Gehäuseinnenbereich über ein Gewinde eingeschraubt, dessen Durchmesser gleich oder kleiner als der Innendurchmesser der Gehäuseflanschinnenfläche ist.

Die erfindungsgemäße Kamera findet überall dort Anwendung, wo ein Einsatz im Freien es erfordert, dass äußeren Witterungseinflüssen, wie Frost und Tau bzw. Kondensierungen, standgehalten wird. Beispielsweise kann eine erfindungsgemäße Kamera zur Überwachung von Grundstücken, öffentlichen Plätzen oder öffentlichen Verkehrsmitteln eingesetzt werden.

Im Rahmen der vorliegenden Beschreibung bedeutet ein "unmittelbares" Anbringen, Anordnen oder Verbinden eines Bauteils an einem anderen Bauteil, dass sich zwischen diesen beiden Bauteilen kein drittes Bauteil befindet. So bedeutet ein unmittelbares Anbringen des Heizelements an einer Platine der Platinengruppe, dass zwischen dem Heizelement und der zugehörigen Platine kein weiteres Element vorhanden ist. Es soll lediglich gestattet sein, beispielsweise einen Kleber, eine Verschraubung oder eine Verschweißung zwischen diesen beiden Bauteilen vorzusehen, so dass die beiden Bauteile immer noch unmittelbar an einander angebracht, angeordnet oder verbunden sind.

Nachfolgend wird die Erfindung beispielhaft anhand der beigefügten Figuren beschrieben, in denen:
- Fig. 1: eine Schnittansicht einer ersten Ausführungsform einer erfindungsgemäßen Kamera mit zumindest einem Heizelement darstellt,
- Fig. 2: eine schematische Draufsicht einer Platine zeigt,
- Fig. 3: eine Schnittansicht einer weiteren Ausführungsform einer erfindungsgemäßen Kamera mit zumindest einem Heizelement zeigt,
- Fig. 4: eine Schnittansicht einer weiteren Ausführungsform einer erfindungsgemäßen Kamera mit zumindest einem Heizelement darstellt,
- Fig. 5: eine Schnittansicht einer weiteren Ausführungsform einer erfindungsgemäßen Kamera mit zumindest einem Heizelement darstellt,
- Fig. 6: eine Schnittansicht einer weiteren Ausführungsform einer erfindungsgemäßen Kamera mit zumindest einem Heizelement darstellt,
- Fig. 7: eine Schnittansicht einer weiteren Ausführungsform einer erfindungsgemäßen Kamera mit zumindest einem Heizelement darstellt, und
- Fig. 8: ein schematisches Schaubild einer Kamera mit Platinenbaugruppe zeigt.

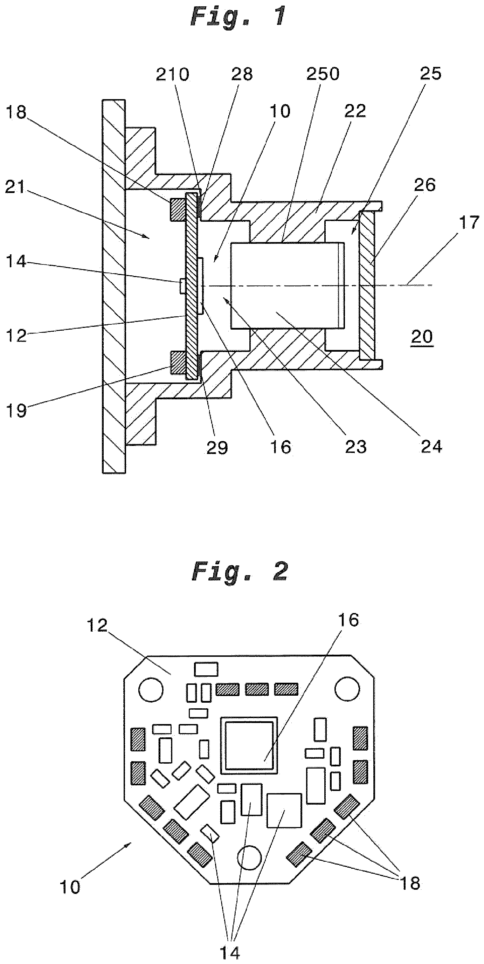

Fig. 1 stellt eine erste Ausführungsform einer erfindungsgemäßen Kamera 20 dar. Die Kamera 20 weist ein Gehäuse 22 auf, das zylindrische Innenbereiche 21, 23, 25 mit unterschiedlichen Durchmessern aufweist. Im Gehäuse 22 befindet sich eine Platinengruppe mit einer einzigen Platine 10, die im Innenbereich 21 angeordnet ist, und ein optisches Element 24, das im Innenbereich 25 mit kleinerem Durchmesser als der Durchmesser des Innenbereichs 21 angeordnet ist. Der Innenbereich 25 ist vom Innenbereich 23 abgestuft und weist eine Gehäuseinnenflanschfläche 210 auf. Die Platine 10 ist an einer Gehäuseinnenflanschfläche 210 befestigt. Das optische Element 24 ist beispielsweise ein Objektiv mit Linsensystem und ist in das Gehäuse 22 im Innenbereich 25, dessen Durchmesser kleiner als der Durchmesser des Innenbereichs 23 ist, über ein Gewinde 250 eingeschraubt. Das Gehäuse 22 ist objektseitig durch ein weiteres optisches Element in Form eines Deckglases 26 luft- und/oder wasserdicht geschlossen. Das Deckglas 26 ist der Umgebung und den Witterungseinflüssen ausgesetzt. Wie der Fig. 1 ferner zu entnehmen ist, ist auf der dem optischen Element 24 zugewandten Seite der Leiterplatte 12 eine digitale Bilderfassungseinheit 16 angebracht, durch die die optische Achse 17 der Kamera verläuft.

In der in der Fig. 1 gezeigten Ausführungsform sind zwei Heizelemente 18, 19 auf der dem optischen Element 24 abgewandten Seite der Leiterplatte 12 der Platine 10 angebracht, beispielsweise mittels einer Widerstandsschicht. Außerdem ist zumindest ein elektronisches Bauteil 14 auf der dem optischen Element 24 abgewandten Seite der Leiterplatte 12 angebracht. Das elektronische Bauteil 14 ist im Sinne der vorliegenden Offenbarung eine aktive Schaltung zur Ausführung von direkten Kamerafunktionen.

Zur Befestigung der Platine 10 am Gehäuse 22 sind zwei Wärmeleitelemente 28, 29 vorgesehen, die zum Übertragen der Wärme von der Leiterplatte 12 in das Gehäuse 22 angepasst sind. Zusätzlich zu den Wärmeleitelementen 18, 19 kann eine Befestigungsvorrichtung vorgesehen sein, die die Platine 10 am Gehäuse 22 fixiert. Das Gehäuse 22, das bevorzugt aus wärmeleitfähigem Material, wie beispielsweise Metall, besteht, kann die von den Heizelementen 18, 19 erzeugte Wärme bis zu den optischen Elementen 24, 26 leiten. Das optische Element 24 erstreckt sich zumindest teilweise vom Innenbereich 25 in den Innenbereich 23.

Bei Ansteuerung der Heizelemente 18, 19 wird zunächst die Leiterplatte 12 erwärmt, wobei auch zumindest teilweise der linke Bereich des Gehäuses 22 (siehe Fig. 1) mittels Konvektion von den Heizelementen 18, 19 erwärmt wird. Die mit den Wärmeleitelementen 28, 29 verbundene erwärmte Leiterplatte 12 leitet die Wärme ins Gehäuse 22 weiter. Die Wärme des Gehäuses 22 wird daraufhin dem optische Element 24 und dem Deckglas 26 über das Gewinde 250 zugeführt und der sich dort befindliche Frost oder Kondensierungen beseitigt oder eine Bildung dergleichen an diesen Bauteilen verhindert. Dabei ist ein langes Gewinde 250, das sich fast über die gesamte Länge des optischen Elements 24 erstreckt, bevorzugt, damit die Wärmeübertragungsfläche zwischen dem Gehäuse 22 und dem optischen Element 24 maximiert ist. Außerdem ist eine Befestigung des Deckglases 26 am Gehäuse 22 mittels einer wärmeleitfähigen Befestigung bevorzugt, damit das Deckglas 26 wirksam erwärmt werden kann.

Fig. 2 zeigt eine schematische Draufsicht auf eine beispielhafte Platine 10, die eine Leiterplatte 12 mit zumindest einem darauf angeordneten elektronischen Bauteil 14 und nicht explizit dargestellten Leitern und Schaltungen aufweist. Auf der Leiterplatte 12 ist die digitale Bilderfassungseinheit 16 angeordnet. Die digitale Bilderfassungseinheit 16 ist beispielsweise ein CCD- oder CMOS-Sensor, der lichtempfindliche elektronische Bauelemente enthält, deren Funktion auf dem inneren Photoeffekt beruhen.

Unmittelbar auf der Leiterplatte 12 ist zumindest ein Heizelement 18 angebracht. In dem in der Fig. 2 gezeigten Beispiel sind insgesamt 13 Heizelemente verteilt auf einer Seite der Leiterplatte 12 angeordnet, wobei die Anzahl der vorgesehenen Heizelemente variieren kann. In weiteren Ausgestaltungen kann zusätzlich oder alternativ zumindest ein Heizelement auf der Rückseite der Leiterplatte 12 angeordnet sein. Bevorzugt befinden sich die Heizelemente 18 am äußeren Rand der Leiterplatte 12. Das wenigstens eine Heizelement 18 ist über die nicht explizit dargestellten Leitungen mit einer Steuerungseinheit (nicht gezeigt) verbunden und wird von dieser gesteuert und mit elektrischer Energie versorgt. Das wenigstens eine Heizelement 18 ist zum Umwandeln der von der Steuereinheit zugeführten elektrischen Energie in Wärmeenergie angepasst.

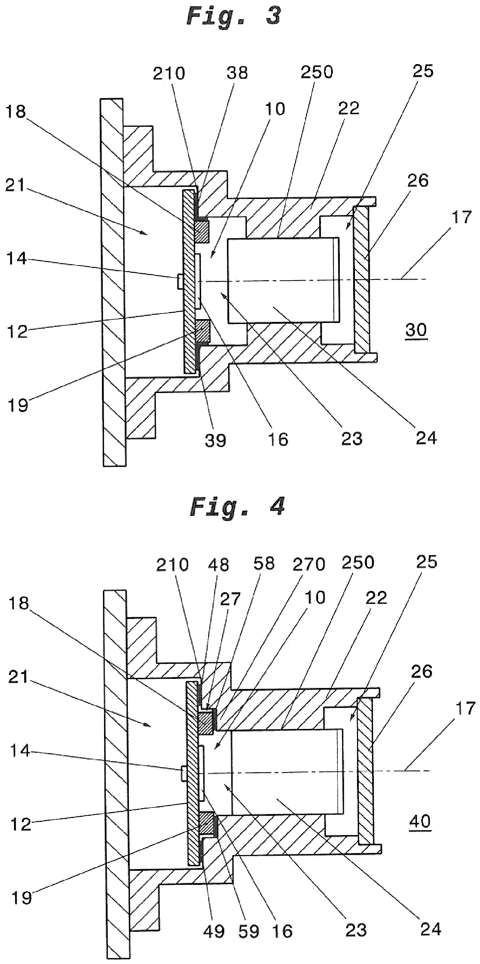

Unter Verweis auf die Fig. 3 ist eine weitere Ausführungsform einer erfindungsgemäßen Kamera 30 dargestellt. Die Kamera 30 der Fig. 3 unterscheidet sich der Kamera 20 der Fig. 2 in der Anordnung der Heizelemente 18, 19 auf der Leiterplatte 12 in Bezug zum optischen Element 24 und in den Wärmeleitelementen 38, 39. Gemäß der Fig. 3 sind zwei Heizelemente 18 auf der dem optischen Element 24 zugewandten Seite der Leiterplatte 12 angebracht. Zwei Wärmeleitelemente 38, 39 sind auf der ringförmigen Gehäuseinnenflanschfläche 210 angebracht und befestigen somit die Platine 10 im Innenbereich 21 am Gehäuse 22. Die zwei Heizelemente 18, 19 erstrecken sich von der Leiterplatte 12 zumindest teilweise in den Innenbereich 23, in den auch das optische Element 24 vorsteht, das wiederum über das Gewinde 250 in das Gehäuse 22 eingeschraubt ist. Gemäß der in der Fig. 3 gezeigten Ausführungsform erstrecken sich die Wärmeleitelemente 38, 39 zwischen der Zylinderfläche des Innenbereichs 23 und der seitlichen Fläche der Heizelemente 18, 19.

Demzufolge können die Heizelemente 18, 19 sowohl die Leiterplatte 12 über den direkten Kontakt als auch die optischen Elements 24, 26 mittels Konvektion erwärmen. Außerdem findet durch die Ausgestaltung der Wärmeleitelemente 38, 39 ein Wärmeübergang sowohl unmittelbar zwischen der Leiterplatte 12 und dem Gehäuse 22, als auch unmittelbar zwischen den Heizelementen 18, 19 und dem Gehäuse 22 statt. Das wärmeleitende Gehäuse 22 kann diese Wärmeenergie bis zu den optischen Elementen 24, 26 leiten.

Bei Aktivierung der Heizelemente 18, 19 wird zunächst unmittelbar die Leiterplatte 12 und über die Wärmeleitelemente 38, 39 das Gehäuse 22 erwärmt. Außerdem findet ein Wärmeübergang zwischen der erwärmten Leiterplatte 12 und dem Gehäuse 22 aufgrund der ebenso dazwischen angeordneten Wärmeleitelemente 38, 39 statt. Das erwärmte Gehäuse 22 kann dann einen Wärmeeintrag in das optische Element 24 und das Deckglas 26 erwirken, um so den Frost und die Kondensierungen darauf entfernen bzw. eine Neubildung derer vermeiden. Ferner können sowohl das Gehäuse 22 als auch das optische Element 24 von den Heizelementen 18, 19 mittels Wärmekonvektion erwärmt werden.

Unter Verweis auf die Fig. 4 ist eine weitere Ausführungsform einer erfindungsgemäßen Kamera 40 dargestellt. Die Kamera 40 der Fig. 4 unterscheidet sich von der Kamera 30 der Fig. 3 in der Ausgestaltung des Gehäuses 22, das zu den Innenbereichen 21, 23, 25 einen zwischen dem Innenbereich 21 und dem Innenbereich 23 angeordneten abgestuften zylindrischen Innenbereich 27 aufweist, und in der Anordnung der Wärmeleitelemente 48, 49, 58, 59. Das Gehäuse 22 weist demnach zusätzlich zu der ringförmigen Gehäuseinnenflanschfläche 210 eine weitere ringförmige Gehäuseinnenflanschfläche 270 auf, die relativ zur Gehäuseinnenflanschfläche 210 parallel abgesetzt ist. Somit ist das Gehäuse 22 mit dem zusätzlichen Innenbereich 27 versehen, in den sich die Heizelemente 18, 19 zumindest teilweise erstrecken. Die Wärmeleitelemente 48, 49 sind, wie bereits in der Fig. 1 gezeigt, unmittelbar zwischen der Leiterplatte 12 und dem Gehäuse 22 an der Gehäuseinnenflanschfläche 210 vorgesehen, um die Wärme der Leiterplatte 12 unmittelbar in das Gehäuse 22 zu übertragen. Die beiden zusätzlichen Wärmeleitelemente 58, 59 sind unmittelbar an der weiteren Gehäuseinnenflanschfläche 270 vorgesehen und stehen mit den Heizelementen 18, 19 und dem Gehäuse 22 in Kontakt, so dass die Wärme von den Heizelementen 18, 19 direkt in das Gehäuse 22 eingebracht wird.

Werden die in der Fig. 4 gezeigten Heizelemente 18, 19 angesteuert, so findet ein unmittelbarer Wärmeeintrag in die Leiterplatte 12 und über die Wärmeleitelemente 58, 59 ins Gehäuse 22 statt. Das Gehäuse 22 wird außerdem über die Wärmeleitelemente 48, 49 von der erwärmten Leiterplatte 12 und über Wärmekonvektion direkt von den Heizelementen 18, 19 erwärmt.

Die in das Gehäuse 22 eingebrachte Wärmeenergie wird dann in das optische Element 24 und das Deckglas 26 geleitet. Das optische Element 24 wird auch direkt von den Heizelementen 18, 19 mittels Wärmekonvektion erwärmt.

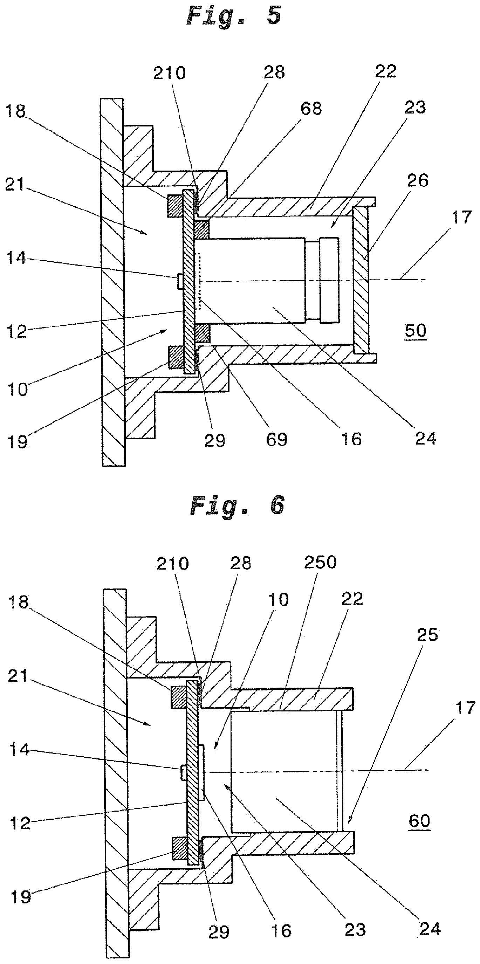

Unter Verweis auf die Fig. 5 ist eine weitere Ausführungsform einer erfindungsgemäßen Kamera 50 dargestellt. Die Kamera 50 der Fig. 5 unterscheidet sich von der Kamera 20 der Fig. 1 in der Ausgestaltung des optischen Elements 24, das, anstatt in das Gehäuse 22 eingeschraubt zu sein, direkt auf der Platine 10 angebracht ist, und in der Anzahl der Heizelemente 18, 19, denn die Kamera 50 weist zusätzlich zu den Heizelementen 18, 19 weitere Heizelemente 68, 69 auf, die an der Leiterplatte 12 auf der den Heizelementen 18, 19 abgewandten Seite angebracht sind. Das optische Element 24 ist zum Anpassen der Schärfe der erfassten Bilder fokussierbar, was mittels der umlaufenden Nut in der Fig. 5 angedeutet ist. Die Heizelemente 68, 69 kontaktieren das optische Element 24, so dass Wärme direkt in das optische Element 24 eingebracht werden kann.

Werden die in der Fig. 5 gezeigten Heizelemente 18, 19, 58, 59 angesteuert, so findet ein unmittelbarer Wärmeeintrag in die Leiterplatte 12 und über die Wärmeleitelemente 28, 29 ins Gehäuse 22 statt. Die linke Seite des Gehäuses 22 wird außerdem über die Heizelemente 18, 19 über Wärmekonvektion erwärmt. Zusätzlich findet ein unmittelbarer Wärmeintrag der Heizelemente 68, 69 in das optische Element 24 und über Wärmekonvektion in das Gehäuse 22 und wenigstens teilweise in das Deckglas 26 statt. Die in das Gehäuse 22 eingebrachte Wärme wird dann bis an das Deckglas 26 geleitet, das erwärmt wird.

Unter Verweis auf die Fig. 6 ist eine weitere Ausführungsform einer erfindungsgemäßen Kamera 60 dargestellt. Die Kamera 60 der Fig. 6 unterscheidet sich von der Kamera 20 der Fig. 1 lediglich darin, dass kein Deckglas 26 vorhanden ist. Die Ausgestaltung der Platine 10, der Heizelemente 18, 19 und der Wärmeleitelemente 28, 29 ist in den Fig. 1 und 6 nahezu identisch. Bei der Kamera 60 ohne Deckglas 26 ist das bevorzugt zu erwärmende Bauteil das optische Element 24, dessen Erwärmungsprinzip dem in Bezug auf die Fig. 1 erläuterten Erwärmungsprinzip entspricht.

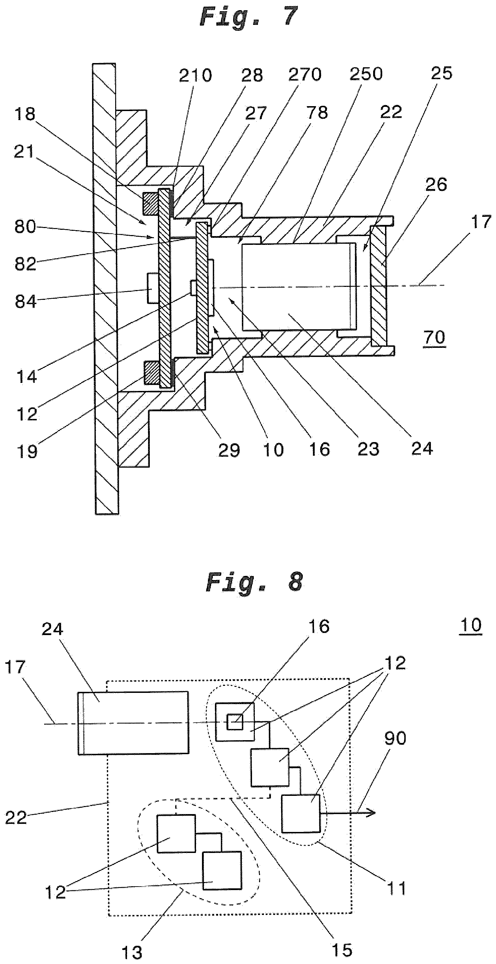

Unter Verweis auf die Fig. 7 ist eine weitere Ausführungsform einer erfindungsgemäßen Kamera 70 dargestellt. Die Kamera 70 der Fig. 7 unterscheidet sich von den zuvor beschriebenen Kameras 20 - 60 darin, dass die Platinengruppe zwei Platinen aufweist, nämlich eine erste Platine 10 eine zweite Platine 80, die über eine elektrische Verbindung 82 miteinander verbunden sind. Auf der Platine 10 ist die digitale Bilderfassungseinheit 16 angebracht. Auf der zweiten Platine 80, die relativ zur ersten Platine 10 auf einer dem optischen Element 24 abgewandten Seite im Gehäuse 22 angeordnet ist, sind die Heizelemente 18, 19 angebracht. Das Gehäuse 22 der Fig. 7 ist mit dem Gehäuse 22 der Fig. 4 nahezu identisch und weist demnach die Innenbereiche 21, 23, 25, 27 mit den Gehäuseinnenflanschflächen 210 und 270 auf. Die zweite Platine 80 ist, ähnlich wie die Platine 10 der Fig. 1, über die Wärmeleitelemente 28, 29 an der Gehäuseinnenflanschfläche 210 befestigt und die erste Platine 10 ist über Befestigungen an der Gehäuseinnenflanschfläche 270 befestigt. Auf der zweiten Platine 80 ist ferner eine aktive Schaltung 84 vorgesehen, die die Kamera zumindest teilweise steuert. Die aktive Schaltung 84 kann in einer weiteren Ausgestaltung beispielsweise eine elektrische Leistungsquelle sein, die sämtliche Platinen der Platinengruppe mit elektrischer Energie versorgt.

Bei der in der Fig. 7 dargestellten Ausführungsform können zusätzlich Heizelemente auf einer oder beiden Seiten der ersten Platine 10 vorgesehen sein, die einen weiteren Wärmeeintrag in das Gehäuse 22 und/oder in das optische Element 24 und/oder Deckglas 26 einbringen. Hierbei sind auch Wärmeleitelemente vorteilhaft, die die von den auf der ersten Platine 10 angeordneten Heizelementen erzeugte Wärme effektiv in das Gehäuse 22 übertragen.

Die Fig. 8 stellt ein schematisches Schaubild einer Kamera 10 dar, bei der das Gehäuse 22 schematisch mit einer gepunkteten Linie dargestellt ist. Im Gehäuse 22 ist zumindest teilweise das optische Element 24 angeordnet. Die optische Achse 17 verläuft durch das optische Element 24 und die digitale Bilderfassungseinheit 16, die auf einer Platine 12 einer ersten Platinengruppe 11 angeordnet ist. Die Platinen 12 der ersten Platinengruppe 11 (in der Fig. 8 weist die erste Platinengruppe 11 beispielhaft drei Platinen auf) weisen jeweils zumindest eine aktive Schaltung auf, die zum Ausführen direkter Kamerafunktionen ausgebildet sind. Außerdem ist in der Fig. 8 eine zweite Platinengruppe 13 dargestellt, die ebenfalls Platinen 12 aufweist (in der Fig. 8 weist die zweite Platinengruppe 13 beispielhaft zwei Platinen auf). Jedoch sind die Platinen 12 der zweiten Platinengruppe 13 zum Ausführen von indirekten Kamerafunktionen angepasst.

Die Platinen 12 der ersten Platinengruppe 11 können über eine Verbindungsleitung 15 mit den Platinen 12 der zweiten Platinengruppe 13 verbunden sein. Die Verbindungsleitung 15 kann der Platinengruppe 13 beispielsweise elektrische Energie zuführen. Jedoch ist die Verbindungsleitung 15 optional. In diesem Fall können die Platinen 12 der zweiten Platinengruppe 13 separat angesteuert werden. Die Videodaten der Platinen 12 der ersten Platinengruppe 11 werden über eine Ausgangsleitung 90 an eine Wiedergabeeinheit zur Darstellung des von der Kamera erfassten Bildes übertragen.

In allen gezeigten Ausführungsformen kann durch den Wärmeeintrag der Heizelementen 18, 19, 68, 69 in das Gehäuse 22 das optische Element 24 und/oder das Deckglas 26 erwärmt und somit die Bildung von Frost oder Kondensierungen auf dem optischen Element 24 und/oder Deckglas 26 vermieden werden. Dabei sei nochmals erwähnt, dass es dasjenige Bauteil ist, das den Witterungseinflüssen der Umgebung direkt ausgesetzt ist, welches erwärmt werden soll. Außerdem können durch den Wärmeeintrag sich bereits auf dem optischen Element 24 und/oder dem Deckglas 26 gebildeter Frost und/oder Kondensierungen beseitigt werden. Ferner ist es mittels der Heizelemente 18, 19, 68, 69 möglich, sowohl das optische Element 24 und/oder Deckglas 26 als auch die elektronischen Bauteile 14 und die digitale Bilderfassungseinheit 16 vor Frost- und/oder Kondensierungsbildung zu schützen oder diese beseitigen.

### Bezugszeichenliste

- 10: Platine
- 11: erste Platinengruppe
- 12: Leiterplatte
- 13: zweite Platinengruppe
- 14: elektronisches Bauteil
- 15: Verbindungsleitung
- 16: digitale Bilderfassungseinheit
- 17: optische Achse
- 18: Heizelement
- 19: Heizelement
- 20: Kamera
- 21: Innenbereich
- 22: Gehäuse
- 23: Innenbereich
- 24: optisches Element
- 25: Innenbereich
- 26: Deckglas
- 27: Innenbereich
- 28: Wärmeleitelement
- 29: Wärmeleitelement
- 30: Kamera
- 38: Wärmeleitelement
- 39: Wärmeleitelement
- 40: Kamera
- 48: Wärmeleitelement
- 49: Wärmeleitelement
- 50: Kamera
- 58: Wärmeleitelement
- 59: Wärmeleitelement
- 60: Kamera
- 68: Heizelement
- 69: Heizelement
- 70: Kamera
- 80: zweite Platine
- 82: Verbindung
- 84: elektrische Schaltung
- 90: Ausgangsleitung
- 210: Gehäuseinnenflanschfläche
- 250: Gewinde
- 270: Gehäuseinnenflanschfläche

## Patentansprüche

1. Kamera (20; 30; 40; 50; 60; 70) zur Verwendung an Fahrzeugen, insbesondere Nutzfahrzeugen, mit:
einem Gehäuse (22),
zumindest einem im oder am Gehäuse (22) angeordneten optischen Element (24, 26),
einer im Gehäuse (22) angeordneten und zumindest eine Platine (10, 80) aufweisenden Platinengruppe (11) mit jeweils zumindest einer aktiven Schaltung zum Ausführen einer direkten Kamerafunktion,
**dadurch gekennzeichnet, dass**
zumindest ein Heizelement (18, 19, 68, 69) zum Erwärmen der Platinengruppe (11), des optischen Elements (24, 26) und/oder des Gehäuses (22) angeordnet und angepasst ist, wobei das zumindest eine Heizelement (18, 19, 68, 69) unmittelbar an einer der Platinen (10, 80) der Platinengruppe (11) angebracht ist, und
zumindest ein Wärmeleitelement (28, 29, 38, 39, 48, 49, 58, 59) zum Übertragen der Wärme des Heizelements (18, 19, 68, 69) und/oder der Platinengruppe (11) in das Gehäuse (22) zwischen dem zumindest einen Heizelement (18, 19, 68, 69) und dem Gehäuse (22) angeordnet und angepasst ist.

2. Kamera (20; 30; 40; 50; 60; 70) nach Anspruch 1, wobei zumindest eine aktive Schaltung eine digitale Bilderfassungseinheit (16) ist.

3. Kamera (20; 30; 40; 50; 60; 70) nach Anspruch 2, wobei die digitale Bilderfassungseinheit (16) und das zumindest eine Heizelement (18, 19, 68, 69) an einer der Platinen (10) der Platinengruppe (11) gemeinsam vorgesehen sind.

4. Kamera (20; 30; 40; 50; 60; 70) nach einem der vorhergehenden Ansprüche, wobei zumindest eine aktive Schaltung zum Übertragen von Videodaten an eine Wiedergabeeinheit angepasst ist.

5. Kamera (20; 30; 40; 50; 60; 70) nach einem der vorhergehenden Ansprüche, wobei zumindest eine aktive Schaltung zum Verarbeiten von Videodaten angepasst ist.

6. Kamera (20; 30; 40; 50; 60; 70) nach einem der vorhergehenden Ansprüche, wobei zumindest eine aktive Schaltung eine elektrische Leistungsquelle ist.

7. Kamera (20; 30; 40; 50; 60; 70) nach einem der vorhergehenden Ansprüche, wobei zumindest ein Heizelement (18, 19, 68, 69) auf einer relativ zum optischen Element (24, 26) abgewandten Seite einer Platine (10, 80) der Platinengruppe (11) angebracht ist.

8. Kamera (20; 30; 40; 50; 60; 70) nach einem der vorhergehenden Ansprüche, wobei zumindest ein Heizelement (18, 19, 68, 69) auf einer relativ zum optischen Element (24, 26) zugewandten Seite einer Platine (10, 80) der Platinengruppe (11) angebracht ist.

9. Kamera (20; 30; 40; 50; 60; 70) nach einem der vorhergehenden Ansprüche, wobei zumindest ein Wärmeleitelement (28, 29, 38, 39, 48, 49, 58, 59) unmittelbar zwischen einer Platine (10, 80) der Platinengruppe (11) und dem Gehäuse (22) angeordnet ist.

10. Kamera (20; 30; 40; 50; 60; 70) nach einem der vorhergehenden Ansprüche, wobei zumindest ein Wärmeleitelement (28, 29, 38, 39, 48, 49, 58, 59) unmittelbar zwischen zumindest einem Heizelement (18, 19, 68, 69) und dem Gehäuse (22) angeordnet ist.

11. Kamera (20; 30; 40; 50; 60; 70) nach einem der vorhergehenden Ansprüche, wobei zumindest ein Wärmeleitelement (28, 29, 38, 39, 48, 49, 58, 59) ein wärmeleitender Kleber, eine Wärmeleitpaste und/oder ein Wärmeleitpad ist.

12. Kamera (20; 30; 40; 50; 60; 70) nach einem der vorhergehenden Ansprüche, wobei zumindest ein Heizelement (18, 19, 68, 69) unmittelbar auf einer Platine (10, 80) der Platinengruppe (11) mittels einer Widerstandsschicht aufgebracht ist.

13. Kamera (20; 30; 40; 50; 60, 70) nach einem der vorhergehenden Ansprüche, ferner mit:
einem im Gehäuse (22) angeordneten Temperatursensor zum Erfassen der Temperatur im Gehäuse (22), und
einer Steuerungseinheit zum Steuern des zumindest einen Heizelements (18, 19, 68, 69) in Abhängigkeit der vom Temperatursensor erfassten Temperatur.

14. Kamera (20; 30; 40; 50; 60; 70) nach einem der vorhergehenden Ansprüche, wobei das zumindest eine Heizelement (18, 19, 68, 69) ein von der Temperatur im Gehäuse (22) abhängiges Heizelement (18, 19, 68, 69) ist, dessen Heizleistung von der im Gehäuse (22) vorherrschenden Temperatur abhängt.

## Claims

1. A camera (20; 30; 40; 50; 60; 70) for use on vehicles, in particular commercial vehicles, comprising:
a housing (22);
at least one optical element (24, 26) disposed within or at the housing (22);
at least one group of circuit boards (11) disposed within the housing (22) and including at least one circuit board (10, 80), the at least one group of circuit boards (11) having at least one active circuit for executing a direct camera function;
**characterized in that**
at least one heating element (18, 19, 68, 69) is arranged and adapted to heat the group of circuit boards (11), the optical element (24, 26) and/or the housing (22), the at least one heating element (18, 19, 68, 69) being directly attached to one of the circuit boards (10, 80) of the group of circuit boards (11); and
at least one heat conducting element (28, 29, 38, 39, 48, 49, 58, 59) is disposed between the at least one heating element (18, 19, 68, 69) and the housing (22) and is adapted to transfer the heat of the heating element (18, 19, 68, 69) and/or the group of circuit boards (11) to the housing (22).

2. The camera (20; 30; 40; 50; 60; 70) according to claim 1, wherein at least one active circuit is a digital image capturing unit (16).

3. The camera (20; 30; 40; 50; 60; 70) according to claim 2, wherein the digital image capturing unit (16) and the at least one heating element (18, 19, 68, 69) are provided together on one of the circuit boards (10) of the group of circuit boards (11).

4. The camera (20; 30; 40; 50; 60; 70) according to any one of the preceding claims, wherein at least one active circuit is adapted to transfer video data to a display unit.

5. The camera (20; 30; 40; 50; 60; 70) according to any one of the preceding claims, wherein at least one active circuit is adapted to process video data.

6. The camera (20; 30; 40; 50; 60; 70) according to any one of the preceding claims, wherein at least one active circuit is an electrical power source.

7. The camera (20; 30; 40; 50; 60; 70) according to any one of the preceding claims, wherein at least one heating element (18, 19, 68, 69) is mounted to a side of a circuit board (10, 80) of the group of circuit boards (11), which side is facing away from the optical element (24, 26).

8. The camera (20; 30; 40; 50; 60; 70) according to any one of the preceding claims, wherein at least one heating element (18, 19, 68, 69) is mounted to a side of a circuit board (10, 80) of the group of circuit boards (11), which side is facing the optical element (24, 26).

9. The camera (20; 30; 40; 50; 60; 70) according to any one of the preceding claims, wherein at least one heat conducting element (28, 29, 38, 39, 48, 49, 58, 59) is directly disposed between a circuit board (10, 80) of the group of circuit boards (11) and the housing (22).

10. The camera (20; 30; 40; 50; 60; 70) according to any one of the preceding claims, wherein at least one heat conducting element (28, 29, 38, 39, 48, 49, 58, 59) is directly disposed between at least one heating element (18, 19, 68, 69) and the housing (22).

11. The camera (20; 30; 40; 50; 60; 70) according to any one of the preceding claims, wherein the at least one heat conducting element (28, 29, 38, 39, 48, 49, 58, 59) is a heat conductive adhesive, a thermal paste and/or a heat conducting pad.

12. The camera (20; 30; 40; 50; 60; 70) according to any one of the preceding claims, wherein at least one heating element (18, 19, 68, 69) is directly attached to a circuit board (10, 80) of the group of circuit boards (11) by means of a resistor layer.

13. The camera (20; 30; 40; 50; 60; 70) according to any one of the preceding claims, further comprising:
a temperature sensor disposed within the housing (22) and configured to detect a temperature within the housing (22); and
a control unit for controlling the at least one heating element (18, 19, 68, 69) as a function of the temperature detected by the temperature sensor.

14. The camera (20; 30; 40; 50; 60; 70) according to any one of the preceding claims, wherein the at least one heating element (18, 19, 68, 69) is a heating element (18, 19, 68, 69) dependent on the temperature within the housing (22), whose heating performance is dependent on the temperature (22) within the housing.

## Revendications

1. Caméra (20 ; 30 ; 40 ; 50 ; 60 ; 70) pour son utilisation sur des véhicules, en particulier des véhicules utilitaires, comportant :
un boîtier (22),
au moins un élément optique (24, 26) disposé dans ou sur le boîtier (22),
un groupe de circuits imprimés (11) disposé dans le boîtier (22) et présentant au moins un circuit imprimé (10, 80) comportant respectivement au moins une commutation active pour la réalisation d'une fonction de caméra directe,
**caractérisée en ce que**
au moins un élément chauffant (18, 19, 68, 69) est disposé et adapté pour le chauffage du groupe de circuits imprimés (11), de l'élément optique (24, 26) et/ou du boîtier (22), dans laquelle l'au moins un élément chauffant (18, 19, 68, 69) est monté directement sur l'un des circuits imprimés (10, 80) du groupe de circuits imprimés (11), et
au moins un élément thermoconducteur (28, 29, 38, 39, 48, 49, 58, 59) est disposé et adapté pour la transmission de la chaleur de l'élément chauffant (18, 19, 68, 69) et/ou du groupe de circuits imprimés (11) dans le boîtier (22) entre l'au moins un élément chauffant (18, 19, 68, 69) et le boîtier (22).

2. Caméra (20 ; 30 ; 40 ; 50 ; 60 ; 70) selon la revendication 1, dans laquelle au moins une commutation active est une unité numérique de saisie d'image (16).

3. Caméra (20 ; 30 ; 40 ; 50 ; 60 ; 70) selon la revendication 2, dans laquelle l'unité numérique de saisie d'image (16) et l'au moins un élément chauffant (18, 19, 68, 69) sont prévus conjointement sur l'un des circuits imprimés (10) du groupe de circuits imprimés (11).

4. Caméra (20 ; 30 ; 40 ; 50 ; 60 ; 70) selon l'une quelconque des revendications précédentes, dans laquelle au moins une commutation active est adaptée pour la transmission de données vidéo à une unité de restitution.

5. Caméra (20 ; 30 ; 40 ; 50 ; 60 ; 70) selon l'une quelconque des revendications précédentes, dans laquelle au moins une commutation active est adaptée pour le traitement de données vidéo.

6. Caméra (20 ; 30 ; 40 ; 50 ; 60 ; 70) selon l'une quelconque des revendications précédentes, dans laquelle au moins une commutation active est une source de puissance électrique.

7. Caméra (20 ; 30 ; 40 ; 50 ; 60 ; 70) selon l'une quelconque des revendications précédentes, dans laquelle au moins un élément chauffant (18, 19, 68, 69) est monté sur un côté d'un circuit imprimé (10, 80) du groupe de circuits imprimés (11), détourné de l'élément optique (24, 26).

8. Caméra (20 ; 30 ; 40 ; 50 ; 60 ; 70) selon l'une quelconque des revendications précédentes, dans laquelle au moins un élément chauffant (18, 19, 68, 69) est monté sur un côté d'un circuit imprimé (10, 80) du groupe de circuits imprimés (11), tourné vers l'élément optique (24, 26).

9. Caméra (20 ; 30 ; 40 ; 50 ; 60 ; 70) selon l'une quelconque des revendications précédentes, dans laquelle au moins un élément thermoconducteur (28, 29, 38, 39, 48, 49, 58, 59) est disposé directement entre un circuit imprimé (10, 80) du groupe de circuits imprimés (11) et le boîtier (22).

10. Caméra (20 ; 30 ; 40 ; 50 ; 60 ; 70) selon l'une quelconque des revendications précédentes, dans laquelle au moins un élément thermoconducteur (28, 29, 38, 39, 48, 49, 58, 59) est disposé directement entre au moins un élément chauffant (18, 19, 68, 69) et le boîtier (22).

11. Caméra (20 ; 30 ; 40 ; 50 ; 60 ; 70) selon l'une quelconque des revendications précédentes, dans laquelle au moins un élément thermoconducteur (28, 29, 38, 39, 48, 49, 58, 59) est un adhésif thermoconducteur, une pâte thermoconductrice et/ou un tampon thermoconducteur.

12. Caméra (20 ; 30 ; 40 ; 50 ; 60 ; 70) selon l'une quelconque des revendications précédentes, dans laquelle au moins un élément chauffant (18, 19, 68, 69) est monté directement sur un circuit imprimé (10, 80) du groupe de circuits imprimés (11) au moyen d'une couche de résistance.

13. Caméra (20 ; 30 ; 40 ; 50 ; 60 ; 70) selon l'une quelconque des revendications précédentes, comportant en outre :
un capteur de température disposé dans le boîtier (22) pour la saisie de la température dans le boîtier (22), et
une unité de commande pour commander l'au moins un élément chauffant (18, 19, 68, 69) en fonction de la température saisie par le capteur de température.

14. Caméra (20 ; 30 ; 40 ; 50 ; 60 ; 70) selon l'une quelconque des revendications précédentes, dans laquelle l'au moins un élément chauffant (18, 19, 68, 69) est un élément chauffant (18, 19, 68, 69) dépendant de la température dans le boîtier (22) dont la puissance de chauffage dépend de la température prépondérante dans le boîtier (22).
